# EUROPEAN PATENT SPECIFICATION

(11) **EP 3 003 720 B1**
(45) Date of publication and mention of the grant of the patent: **18.08.2021**
(21) Application number: 14804066.0
(22) Date of filing: 27.02.2014
(51) Int. Cl.: B32B 37/06, B32B 37/12, B32B 15/01, B32B 18/00, C04B 37/00, C04B 37/02, C23C 14/58, C23C 16/56, C23C 24/04, C23C 28/00

(54) **PRECIPITATION HARDENED PARTIAL TRANSIENT LIQUID PHASE BOND**
AUSSCHEIDUNGSGEHÄRTETE TEILWEISE FLÜCHTIGE FLÜSSIG-PHASENBINDUNG
LIAISON EN PHASE LIQUIDE PARTIELLEMENT TRANSITOIRE ET DURCIE PAR PRÉCIPITATION

(30) Priority: 30.05.2013 US 201361829009 P
(43) Date of publication of application: 13.04.2016
(73) Proprietor: Raytheon Technologies Corporation, Farmington, CT 06032 (US)
(72) Inventor: COOK, Grant O., Tolland, CT 06084 (US)
(74) Representative: Dehns
(86) International application number: PCT/US2014/019013
(87) International publication number: WO 2014/193506

(56) References cited:
- EP-A1- 0 117 671
- EP-A1- 1 642 667
- EP-B1- 1 042 103
- EP-B1- 1 042 103
- US-A- 5 234 152
- US-A- 5 234 152
- US-A1- 2005 098 609
- US-A1- 2008 035 707
- GRANT O COOK III ET AL: "Overview of transient liquid phase and partial transient liquid phase bonding", JOURNAL OF MATERIALS SCIENCE, KLUWER ACADEMIC PUBLISHERS, BO, vol. 46, no. 16, 7 May 2011 (2011-05-07), pages 5305-5323, XP019907409, ISSN: 1573-4803, DOI: 10.1007/S10853-011-5561-1

## Description

### FIELD OF THE DISCLOSURE

The present invention relates to a precipitation-hardened partial transient liquid phase bond and method of making same. More specifically, the invention relates to a method of applying a ceramic coating on a metallic substrate using precipitation hardening of a partial transient liquid phase bond.

### BACKGROUND OF THE DISCLOSURE

Ceramic-plated metallic or composite materials consist of a metallic or composite substrate coated with ceramic. These materials are lightweight and, by virtue of the ceramic plating, exhibit markedly enhanced thermal strengths over the strength of the metallic or composite substrate alone. These properties have made them attractive materials for component fabrication in many industries such as aerospace, automotive, and military equipment industries, where lightweight thermally resistant structures are desired. For example, ceramic-coated metallic materials continue to be explored for use in gas turbine engine applications to reduce the overall weight of the engine and improve engine efficiency and fuel savings. However, the strength and performance characteristics of ceramic-plated materials may be dependent upon the integrity of the interfacial bond between the ceramic plating and the underlying metallic or composite substrate. As such, the ceramic coating may become disengaged from the substrate surfaces.

The interfacial bond strength between the ceramic plating and the underlying substrate also may be compromised upon exposure to high temperatures, such as those experienced during some high-temperature engine operations. If ceramic-coated components are exposed to temperatures over a critical temperature or critical temperature range during operation, the interfacial bond between the ceramic coating and the substrate may be at least partially degraded, which may lead to structural break-down of the component and possible in-service failure. To provide performance characteristics necessary for the safe use of ceramic-coated materials in gas turbine engines and other applications, strategies are needed to improve the interfacial bond strength and the high temperature stability of the ceramic-coated materials.

Transient liquid phase (TLP) and partial transient liquid phase (PTLP) bonding processes have been found to be useful alternatives to welding and brazing as ways to bond metals and ceramics. PTLP bonding is often performed with elemental interlayers designed to eventually form a solid solution after isothermal solidification and subsequent homogenization steps. However, the resulting strength of the solid-solution bond may not be sufficient for certain applications, especially in the aerospace industry. The present disclosure is directed to solving this problem by providing a method for achieving a stronger bond in a PTLP bonding process.

GRANT O COOK III ET AL: "Overview of transient liquid phase and partial transient liquid phase bonding", JOURNAL OF MATERIALS SCIENCE, KLUWER ACADEMIC PUBLISHERS, BO, vol. 46, no. 16, 7 May 2011 (2011-05-07), pages 5305-5323 XP019907409, ISSN: 1573-4803, DOI: 10.1007/S10853-011-5561-1, at pages 5313 to 5318, discloses the use of PTLP bonding. An interlayer consists of thin layers of low-melting-point metals or alloys on each side of a thicker refractory metal or alloy layer. Upon heating to a bonding temperature a liquid is formed by each thin layer. This is followed by isothermal solidification and homogenization processes.

### SUMMARY OF THE DISCLOSURE

The present invention relates to a precipitation-hardened partial transient liquid phase bond and method of making same, as disclosed in the appended claims.

### BRIEF DESCRIPTION OF THE DRAWINGS

FIG. 1 is a schematic representation illustrating an assembly for forming a precipitation-hardened partial transient liquid phase bond between a first material and a second material in accordance with the present invention.
FIG. 2 is a flow diagram illustrating steps involved in the creation of a precipitation hardened partial transient liquid phase bond in accordance with a method of the present invention.
FIG. 3 is a phase diagram corresponding to a multi-layer interlayer and exhibiting eutectic melting used in making a precipitation-hardened partial transient liquid phase bond according to the invention.
FIG. 4 is a phase diagram corresponding to a multi-layer interlayer and exhibiting direct (or peritectic) melting used in making a precipitation-hardened partial transient liquid phase bond according to the invention.

It should be understood that the drawings are not necessarily drawn to scale and that the disclosed embodiments are sometimes illustrated diagrammatically and in partial views.

### DETAILED DESCRIPTION

The present invention relates to a precipitation-hardened partial transient liquid phase bond and method of making same. Basically, a PTLP bond is created at one temperature and then, based on the phase diagrams corresponding to the the materials in the interlayer, the bond is held at a lower heat-treatment temperature to achieve a precipitation-hardened structure.

Transient liquid phase (TLP) bonding is a process that joins materials using an interlayer. When the interlayer is heated it melts and at least one element diffuses into the materials being joined, causing isothermal solidification of the bond.

The TLP bonding process generally involves the following steps:
1. Placing a thin interlayer between the materials to be bonded to create an assembly;
2. Heating the assembly to the bonding temperature to produce a liquid in the bond region;
3. Holding the assembly at the bonding temperature until the liquid has isothermally solidified due to diffusion; and
4. Homogenizing the bond at a suitable heat-treating temperature.

The bond process may consist of placing a thin interlayer between opposing materials, such as a metallic plating and a metallic substrate. The interlayer can be in many forms, including thin foil, powder, paste, vapor deposition, or electroplating. Pressure may be applied to the opposing materials, and various heat sources used, including radiation, conduction, and radio-frequency induction.

TLP bonding may be used to bond metallic coatings or platings onto the surface of a substrate. Although some conventional coating methods for metallic materials (e.g., cold spraying) may provide a mechanical interlock between the metallic substrate and the coating, TLP bonding may provide a more robust bond between the coating and the substrate. The main advantage of TLP bonding is that the resulting bond between the coating and the substrate typically has a melting temperature above the temperature used for TLP bonding so that the formed bond may operate at temperatures well above the bonding temperature. This feature may be advantageous, for example, when joining temperature-sensitive metals whose microstructures could be damaged by too much thermal energy input. TLP bonding is often used in high-temperature applications where welding, brazing, and diffusion brazing cannot be used. The interlayer material may be any metallic material.

Partial transient liquid phase (PTLP) bonding is a variant of TLP typically used to join ceramics. In PTLP bonding, the interlayer may comprise thin layers of low-melting point metals or alloys on each side of a thicker refractory metallic layer. Among the advantages of PTLP bonding are the following: (1) The dual nature of the multi-layer interlayer combines some beneficial properties of brazing and diffusion bonding. (2) Lower bonding temperatures can minimize thermally induced stresses.

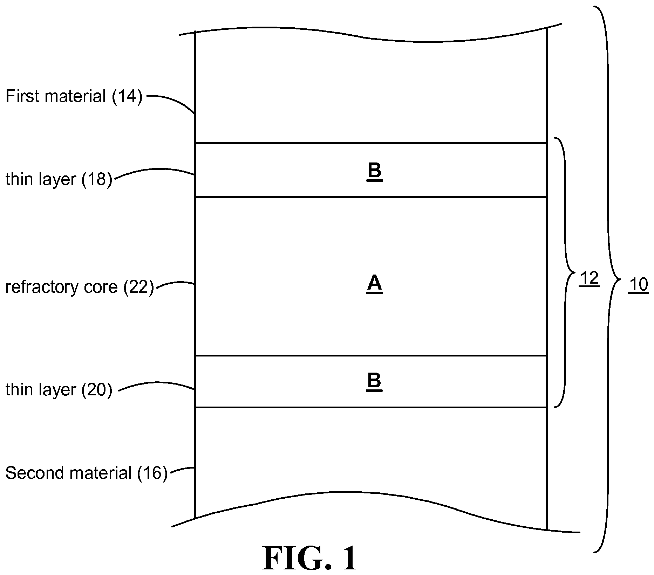

Figure 1 is a schematic of a PTLP bonding assembly 10 according to the invention. The assembly 10 comprises a multi-layer interlayer 12 disposed between a first material 14 and a second material 16. The first material 14 may be a coating or plating, including a ceramic coating. The second material 16 may be a substrate, such as structure made of metallic, ceramic, or composite materials. The substrate may be a component of a jet engine. The first material 14 may be applied to one or more surfaces of the second material 16 and may be capable of imparting the second material 16 with one or more properties favorable to its operation and use, such as hardness or enhanced thermal stability. The first material 14 may be applied to the surfaces of the second material 16 using any conventional means, including chemical vapor deposition, physical vapor deposition, cold spraying, or plasma spraying. The first material 14 may be non-metallic while the second material 16 is metallic. Alternatively, the first material 14 and the second material 16 may both be non-metallic.

The depicted interlayer 12 consists of thin layers 18 and 20 on either side of a refractory layer or core 22, but it should be understood that there can be multiple layers on each side of the refractory layer 22. As explained in more detail below, the thin layers 18 and 20 melt and diffuse into the thicker refractory core 22 during the bonding process while the refractory core 22 stays solid. The refractory layer 22 may be made of a refractory material including without limitation a metallic material and the thin layers 18 and 20 may be made of a material having a lower melting point than the refractory material 22. Also, thin layer 18 and thin layer 20 can be composed of different metallic materials.

Figure 2 is a flow-chart diagram illustrating steps involved in the creation of a precipitation-hardened partial transient liquid phase bond in accordance with a method of the present invention. The method may comprise the following steps:
Step 100: Placing a multi-layer interlayer 12 of metallic materials between a first material 14 and a second material 16 to create an assembly 10. As noted above, the interlayer 12 may comprise thin layers 18 and 20 on either side of a relatively thicker refractory layer 22. The first material 14 may be a coating, such as a ceramic coating, to be applied to a second material or substrate 16, such as a metallic component. The multi-layer interlayer 12 may be applied to the surface of the second (substrate) material 14 by any conventional means, including foil layup, powder application, plating, chemical vapor deposition, physical vapor deposition, cold spraying, or plasma spraying. The first (coating) material 14 may then be applied over the interlayer 12 using any suitable means.
Step 102: Heating the assembly 10 to a bonding temperature T_{bond} to produce a liquid in the bonding region, e.g., the region of contact between the first and second materials 14 and 16 to be bonded together. Heating may be accomplished by any conventional means, such as radiation, conduction, radio-frequency induction, resistance, laser, or infrared heating, and can cause direct or eutectic melting in the interlayer.
Step 104: Holding the assembly 10 at the bonding temperature T_{bond} for a suitable time until the liquid has isothermally solidified due to diffusion within the interlayer 12 to create a sufficiently homogenized interlayer 12. The bonding time depends on the materials in the assembly 10, particularly the materials in the interlayer 12.
Step 106: Precipitation hardening the bonded interlayer 12 by holding the assembly 10 at a hardening temperature T_{PH} lower than the bonding temperature T_{bond} for a specified period of time, thereby creating a precipitation-hardened PTLP bond. The assembly 10 may be cooled below the hardening temperature T_{PH} and then heated back up to the hardening temperature T_{PH}, or simply cooled down from the bonding temperature T_{bond} to the hardening temperature T_{PH} and held there until the bond is hardened.

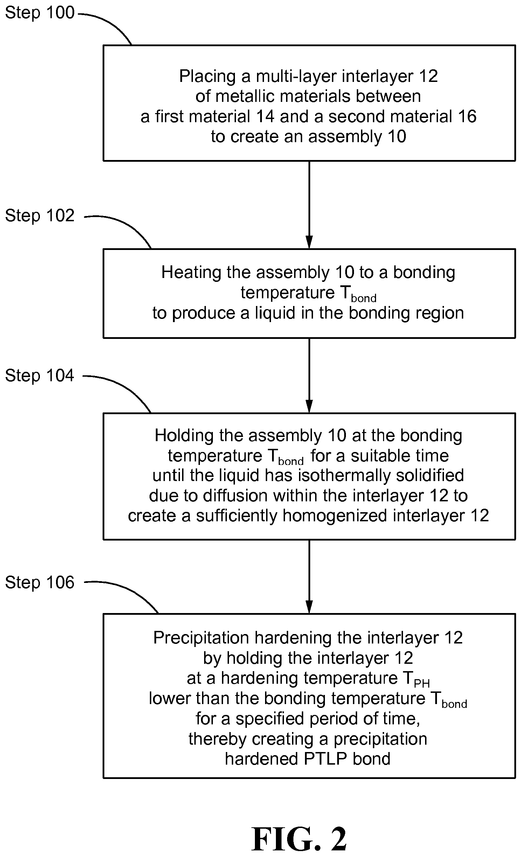

Figure 3 is a phase diagram of a two-component (binary) interlayer 12 used in making a precipitation-hardened partial transient liquid phase bond according to the disclosure. The two components may be any suitable components, such as metallic elements, and are indicated here as A and B. Temperature is shown on the vertical (Y) axis. The horizontal (X) axis depicts the concentration of element A in element B, where element A is the higher-melting-point material, and thus the material that makes up the refractory core 22 (Fig. 1). Element B has a lower melting point than element A and thus makes up the thin layers 18 and 20. The left hand side of the diagram represents 100% B while the right side represents 100% A.

As shown in the diagram, when the multi-layer interlayer 12 is heated to a bonding temperature (T_{bond}), the thin layers of element B diffuse into element A and liquefy as indicated by the eutectic trough E. The vertical line EC intersecting the eutectic trough E represents the eutectic composition of A and B, which is about 1/3 B and 2/3 A. In other words, a liquid is formed through a eutectic reaction with the refractory core 22 by each thin layer 18 and 20 of element B. The liquid that is formed wets the first and second materials 14 and 16 while diffusing into the solid refractory core 22. Holding the assembly 10 at the bonding temperature T_{bond} causes the liquid to solidify isothermally due to homogenization of the entire bond region, creating a refractory bond.

The vertical line S represents a stoichiometric intermetallic phase, which in the diagram is approximately 40% element A and 60% element B, according to the Gibbs' phase rule. This intermetallic phase will form at the interface between element A and and element B while continued diffusion into the refractory core 22 will eventually cause the interlayer 12 to become completely homogenous.

After creating an homogenous interlayer 12, the composition of the interlayer 12, represented by point T1 in the phase diagram, is similar to that of an alloy after solution heat treating. The particles of element B in the interlayer 12 have gone into solution in element A and are equally distributed throughout the interlayer 12.

Next, the interlayer 12 is held at a hardening temperature T_{PH} lower than the bonding temperature T_{bond} as represented by point T2 for a specified period of time, thereby creating a precipitation-hardened PTLP bond. The hardening time typically is longer than the bonding time. By maintaining the assembly 10 for a sufficient amount of time at the lower hardening temperature T_{PH}, the particles start to precipitate and form a structure that is hardened by the intermetallic particles, whose composition is represented by the vertical line S and which are evenly distributed throughout the interlayer structure 12.

Thus the interlayer may be a mixture of two metallic elements A and B which can exist in one or more phases depending on temperature and relative concentrations of the two elements. A phase diagram of the mixture like that shown in Figure 3 may include a two-phase region. The bonding temperature T_{bond} and the interlayer thicknesses are selected to yield a solid-solution composition just outside the two-phase region.

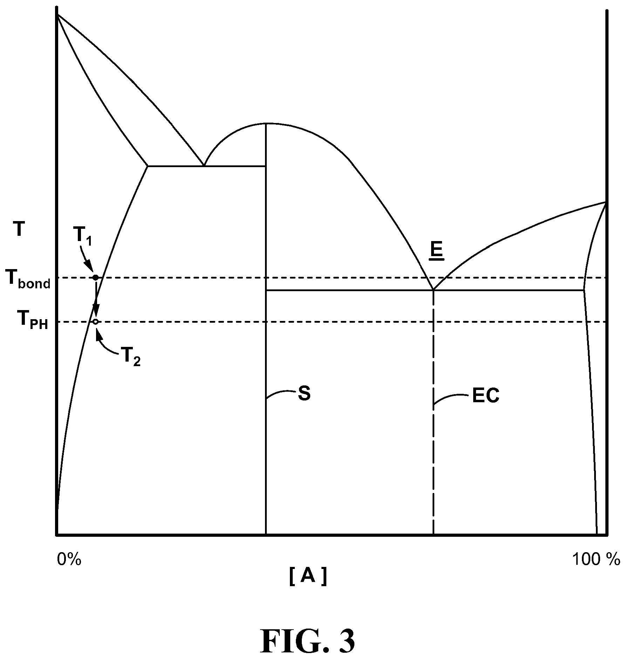

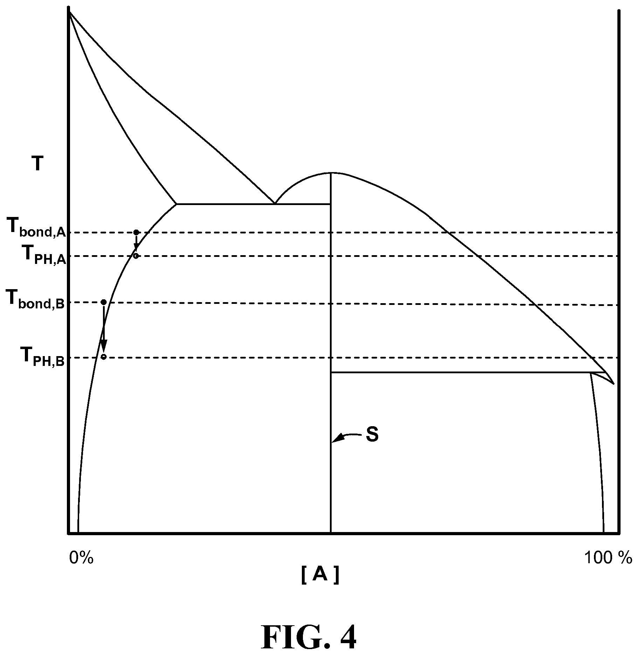

Figure 4 is a phase diagram of another two-component (binary) interlayer 12 used in making a precipitation-hardened partial transient liquid phase bond according to the disclosure, wherein the interlayer melting is accomplished via direct melting of the relatively thinner layers (element A). Two potential sets (T_{A} and T_{B}) of bonding and hardening temperatures are shown in the diagram. It is readily apparent from the diagram that the difference between the bonding temperature T_{bon,A} and the hardening temperature T_{PH,A} of temperature set A is less than the difference between the bonding temperature T_{bond,B} and the hardening temperature T_{PH,B} of temperature set B. Since the advantages of a precipitation-hardened bonded assembly are limited to operating at or below the precipitation-hardening temperature T_{PH}, it is desirable to keep the bonding temperature T_{bond} and the hardening temperature T_{PH} close together. Operating a precipitation-hardened PTLP bond above T_{PH} will cause the bond to homogenize (solution heat treat) and revert to a typical, solid-solution PTLP bond. Thus, set A in the diagram is the preferred set of bonding and hardening temperatures, even though the assembly resulting from the set B temperatures has a higher absolute remelting temperature (when comparing typical, solid-solution PTLP bonds) because the operating temperature limit T_{PH,A} for set A is higher than the operating temperature limit T_{PH,B} for set B. Furthermore, the higher strength capability at lower temperatures of the precipitation-hardened bond resulting from the set A temperatures can be of greater benefit than the higher temperature capability of a typical solid-solution PTLP bond resulting from the lower, set B, temperatures.

With respect to the interlayer 12 shown in FIG. 1 and demonstrated in FIGs. 3 and 4, the thin layer 18 and the thin layer 20 can be composed of different metallic materials. To achieve a precipitation-hardened PTLP bond in this case, the relevant ternary phase diagram and/or both associated binary phase diagrams should be assessed to determine the interlayer thicknesses, bonding temperature T_{bond}, and hardening temperature T_{PH}.

### Benefits/Industrial Applicability

From the foregoing, it can therefore be seen that the present invention can find industrial applicability in many situations, including, but not limited to, industries requiring light-weight and high-strength hybrid components having improved strength and wear resistance, including components that operate in high-temperature environments, such as combustors in jet engines. The technology as disclosed herein can provide components encapsulated in one or more ceramic coating layers to increase the temperature resistance of the component, resist delamination, and improve the resistance of the coating against environmental effects such as erosion and foreign-object damage. Furthermore, as disclosed herein, ceramic plating layers may be introduced on the surface of ceramic, metallic, or composite components to provide delamination-resistant hybrid composite structures having ceramic plating layers. The technology as disclosed herein may find wide industrial applicability in a wide range of areas including, but not limited to, aerospace industries, automotive industries, and sporting industries.

In particular, this disclosure can find applicability bonding a metallic coating to a non-metallic substrate, a metallic substrate to a non-metallic substrate, or a non-metallic substrate to a non-metallic substrate.

## Claims

1. A method of bonding a first material (14) to a second material (16), the first material and second material defining a bonding region, the method comprising the steps of:
placing a multi-layer interlayer (12) of metallic materials between the first material (14) and the second material (16) to create an assembly, the interlayer (12) having a thickness;
heating the assembly to a bonding temperature to produce a liquid in the bonding region;
holding the assembly at the bonding temperature for a suitable time until the liquid has isothermally solidified due to diffusion within the interlayer (12) and until a sufficiently homogenized interlayer has been created; and
precipitation hardening the interlayer (12) by holding the interlayer at a hardening temperature lower than the bonding temperature for a specified period of time, thereby creating a precipitation-hardened PTLP bond.

2. The method of claim 1 wherein the number of layers (18,20,22) in the multi-layer interlayer (12) is three.

3. The method of claim 2 wherein:
the interlayer (12) comprises thin layers (18,20) and disposed on either side of a refractory layer (22).

4. The method of claim 3 wherein:
the refractory layer (22) is made of a refractory material and the thin layers (18,20) are made of a material having a lower melting point than the refractory material.

5. The method of claim 4 wherein:
the thin layers (18,20) and the refractory layer (22) are made of metallic materials.

6. The method of claim 1 wherein:
the first material (14) is non-metallic and the second material (16) is metallic.

7. The method of claim 6 wherein:
the first material (14) is ceramic.

8. The method of claim 1 wherein:
the first material (14) is non-metallic and the second material (16) is non-metallic.

9. The method of claim 1 wherein:
the interlayer (12) is a mixture of two metallic elements which can exist in one or more phases depending on temperature and relative concentrations of the two elements;
a phase diagram of the mixture includes a two-phase region; and
the bonding temperature and the interlayer thickness are selected to yield a solid-solution composition just outside the two-phase region.

10. A bonded assembly (10) comprising:
a first material (14) bonded to a second material (16) by a precipitation-hardened PTLP bond.

11. The bonded assembly (10) of claim 10 further comprising:
an interlayer (12) that has a thickness and comprises a refractory layer (22) made of a refractory component and having a thickness, the refractory layer interposed between relatively thinner thin layers (18,20) each made of a component different from the refractory component;
wherein the interlayer (12) has been heated to a bonding temperature to produce a liquid, held at the bonding temperature for a suitable time until the liquid has isothermally solidified due to diffusion within the interlayer and has created a sufficiently homogenized interlayer, and precipitation-hardened by holding the interlayer at a hardening temperature lower than the bonding temperature for a specified period of time.

12. The bonded assembly (10) of claim 11 wherein:
the interlayer (12) is a mixture of two metallic elements which can exist in one or more phases depending on temperature and relative concentrations of the two elements;
a phase diagram of the mixture includes a two-phase region; and
the bonding temperature and interlayer thicknesses are selected to yield a solid-solution composition just outside the two-phase region of the interlayer components.

13. The bonded assembly (10) of claim 11 wherein:
the two thin layers (18,20) are made of the same material, or the two thin layers (18,20) are made of different materials, or the refractory layer (22) is made of a refractory material and the thin layers (18,20) are made of a second material having a lower melting point than the refractory material, or the thin layers (18,20) and the refractory layer (22) are made of metallic materials, or the first material (14) is non-metallic and the second material (16) is metallic, or the first material (14) is non-metallic and the second material (16) is non-metallic.

14. The bonded assembly (10) of claim 10, further comprising:
an interlayer (12) disposed between the first and second materials (14,16), the interlayer (12) comprising an isothermally-solidified, precipitation-hardened homogenized mixture of a metallic refractory element and a metallic thin layer element having a lower melting point than the metallic refractory material.

15. The bonded assembly (10) of claim 14 wherein:
the first material (14) is a ceramic coating; and
the second material (16) is a metallic substrate.

## Patentansprüche

1. Verfahren zum Bonden eines ersten Materials (14) an ein zweites Material (16), wobei das erste Material und das zweite Material einen Bondbereich definieren, wobei das Verfahren die folgenden Schritte umfasst:
Anordnen einer mehrlagigen Zwischenschicht (12) aus metallischen Materialien zwischen dem ersten Material (14) und dem zweiten Material (16), um eine Baugruppe zu erzeugen, wobei die Zwischenschicht (12) eine Dicke aufweist;
Erwärmen der Baugruppe auf eine Bondtemperatur, um eine Flüssigkeit in dem Bondbereich zu bilden;
Halten der Baugruppe über eine geeignete Zeit auf der Bondtemperatur, bis die Flüssigkeit aufgrund der Diffusion innerhalb der Zwischenschicht (12) isothermisch gehärtet ist und bis eine ausreichend homogenisierte Zwischenschicht erzeugt wurde; und
Ausscheidungshärten der Zwischenschicht (12) durch Halten der Zwischenschicht auf einer Härtetemperatur, die niedriger als die Bondtemperatur ist, über einen bestimmten Zeitraum, wodurch ein ausscheidungsgehärteter PTLP-Bond erzeugt wird.

2. Verfahren nach Anspruch 1, wobei die Anzahl von Lagen (18, 20, 22) in der mehrlagigen Zwischenschicht (12) drei beträgt.

3. Verfahren nach Anspruch 2, wobei:
die Zwischenschicht (12) Dünnschichten (18, 20) umfasst und an beiden Seiten einer hochschmelzenden Schicht (22) angeordnet sind.

4. Verfahren nach Anspruch 3, wobei:
die hochschmelzende Schicht (22) aus einem hochschmelzenden Material hergestellt ist und die dünnen Schichten (18, 20) aus einem Material hergestellt sind, das einen niedrigeren Schmelzpunkt als das hochschmelzende Material aufweist.

5. Verfahren nach Anspruch 4, wobei: die dünnen Schichten (18, 20) und die hochschmelzende Schicht (22) aus metallischen Materialien hergestellt sind.

6. Verfahren nach Anspruch 1, wobei:
das erste Material (14) nicht metallisch ist und das zweite Material (16) metallisch ist.

7. Verfahren nach Anspruch 6, wobei:
das erste Material (14) keramisch ist.

8. Verfahren nach Anspruch 1, wobei:
das erste Material (14) nicht metallisch ist und das zweite Material (16) nicht metallisch ist.

9. Verfahren nach Anspruch 1, wobei:
die Zwischenschicht (12) ein Gemisch aus zwei metallischen Elementen ist, das in einer oder mehreren Phasen abhängig von der Temperatur und den relativen Konzentrationen der zwei Elemente vorliegen kann;
ein Phasendiagramm des Gemisches einen Zweiphasenbereich beinhaltet; und
die Bondtemperatur und die Zwischenschichtdicke so ausgewählt sind, dass eine feste Lösungszusammensetzung knapp außerhalb des Zweiphasenbereichs erreicht wird.

10. Gebondete Baugruppe (10), umfassend:
ein erstes Material (14), das an ein zweites Material (16) durch einen ausscheidungsgehärteten PTLP-Bond gebondet ist.

11. Gebondete Baugruppe (10) nach Anspruch 10, ferner Folgendes umfassend:
eine Zwischenschicht (12), die eine Dicke aufweist und eine hochschmelzende Schicht (22) umfasst, die aus einer hochschmelzenden Komponente hergestellt ist und eine Dicke aufweist, wobei die hochschmelzende Schicht zwischen relativ dünneren Dünnschichten (18, 20) angeordnet ist, die jeweils aus einer Komponente hergestellt sind, die sich von der hochschmelzenden Komponente unterscheidet;
wobei die Zwischenschicht (12) auf eine Bondtemperatur erwärmt wurde, um eine Flüssigkeit zu bilden, auf der Bondtemperatur über eine geeignete Zeit gehalten wurde, bis die Flüssigkeit aufgrund der Diffusion innerhalb der Zwischenschicht isothermisch gehärtet ist und bis eine ausreichend homogenisierte Zwischenschicht erzeugt ist, und durch Halten der Zwischenschicht auf einer Härtetemperatur, die niedriger als die Bondtemperatur ist, über einen bestimmten Zeitraum ausscheidungsgehärtet ist.

12. Gebondete Baugruppe (10) nach Anspruch 11, wobei:
die Zwischenschicht (12) ein Gemisch aus zwei metallischen Elementen ist, das in einer oder mehreren Phasen abhängig von der Temperatur und den relativen Konzentrationen der zwei Elemente vorliegen kann;
ein Phasendiagramm des Gemisches einen Zweiphasenbereich beinhaltet; und
die Bondtemperatur und die Zwischenschichtdicke so ausgewählt sind, dass eine feste Lösungszusammensetzung knapp außerhalb des Zweiphasenbereichs der Zwischenschichtkomponenten erreicht wird.

13. Gebondete Baugruppe (10) nach Anspruch 11, wobei:
die zwei Dünnschichten (18, 20) aus dem gleichen Material hergestellt sind oder die zwei Dünnschichten (18, 20) aus unterschiedlichen Materialien hergestellt sind, oder die hochschmelzende Schicht (22) aus einem hochschmelzenden Material hergestellt ist und die Dünnschichten (18, 20) aus einem zweiten Material hergestellt sind, die einen niedrigeren Schmelzpunkt als das hochschmelzende Material aufweisen, oder die Dünnschichten (18, 20) und die hochschmelzende Schicht (22) aus metallischen Materialien hergestellt sind, oder das erste Material (14) nicht metallisch ist und das zweite Material (16) metallisch ist, oder das erste Material (14) nicht metallisch ist und das zweite Material (16) nicht metallisch ist.

14. Gebondete Baugruppe (10) nach Anspruch 10, ferner Folgendes umfassend:
eine Zwischenschicht (12), die zwischen dem ersten und dem zweiten Material (14, 16) angeordnet ist, wobei die Zwischenschicht (12) ein isothermisch gehärtetes, ausscheidungsgehärtetes homogenisiertes Gemisch aus einem metallischen hochschmelzenden Element und einem metallischen Dünnschichtelement umfasst, das einen niedrigeren Schmelzpunkt als das metallische hochschmelzende Material aufweist.

15. Gebondete Baugruppe (10) nach Anspruch 14, wobei:
das erste Material (14) eine keramische Beschichtung ist; und
das zweite Material (16) ein metallisches Substrat ist.

## Revendications

1. Procédé de liaison d'un premier matériau (14) à un second matériau (16), le premier matériau et le second matériau définissant une région de liaison, le procédé comprenant les étapes de :
de placement d'une couche intermédiaire multicouche (12) de matériaux métalliques entre le premier matériau (14) et le second matériau (16) pour créer un ensemble, la couche intermédiaire (12) ayant une épaisseur ;
de chauffage de l'ensemble à une température de liaison pour produire un liquide dans la région de liaison ;
de maintien de l'ensemble à la température de liaison pendant une durée appropriée jusqu'à ce que le liquide se soit solidifié de manière isotherme en raison de la diffusion à l'intérieur de la couche intermédiaire (12) et jusqu'à ce qu'une couche intermédiaire suffisamment homogénéisée ait été créée ; et
de durcissement par précipitation de la couche intermédiaire (12) en maintenant la couche intermédiaire à une température de durcissement inférieure à la température de liaison pendant une période de temps spécifiée, créant ainsi une liaison PTLP durcie par précipitation.

2. Procédé selon la revendication 1, dans lequel le nombre de couches (18, 20, 22) dans la couche intermédiaire multicouche (12) est de trois.

3. Procédé selon la revendication 2, dans lequel :
la couche intermédiaire (12) comprend des couches minces (18, 20) et disposées de part et d'autre d'une couche réfractaire (22) .

4. Procédé selon la revendication 3, dans lequel :
la couche réfractaire (22) est constituée d'un matériau réfractaire et les couches minces (18, 20) sont constituées d'un matériau ayant un point de fusion inférieur à celui du matériau réfractaire.

5. Procédé selon la revendication 4, dans lequel :
les couches minces (18, 20) et la couche réfractaire (22) sont constituées de matériaux métalliques.

6. Procédé selon la revendication 1, dans lequel :
le premier matériau (14) est non métallique et le second matériau (16) est métallique.

7. Procédé selon la revendication 6, dans lequel :
le premier matériau (14) est de la céramique.

8. Procédé selon la revendication 1, dans lequel :
le premier matériau (14) est non métallique et le second matériau (16) est non métallique.

9. Procédé selon la revendication 1, dans lequel :
la couche intermédiaire (12) est un mélange de deux éléments métalliques qui peuvent exister en une ou plusieurs phases en fonction de la température et des concentrations relatives des deux éléments ;
un diagramme de phases du mélange comporte une région à deux phases ; et
la température de liaison et l'épaisseur de couche intermédiaire sont choisies pour produire une composition de solution solide juste à l'extérieur de la région à deux phases.

10. Ensemble lié (10) comprenant :
un premier matériau (14) lié à un second matériau (16) par une liaison PTLP durcie par précipitation.

11. Ensemble lié (10) selon la revendication 10, comprenant en outre :
une couche intermédiaire (12) qui a une épaisseur et comprend une couche réfractaire (22) constituée d'un composant réfractaire et ayant une épaisseur, la couche réfractaire étant interposée entre des couches minces (18, 20) relativement plus minces chacune constituée d'un composant différent du composant réfractaire ;
dans lequel la couche intermédiaire (12) a été chauffée à une température de liaison pour produire un liquide, maintenue à la température de liaison pendant une durée appropriée jusqu'à ce que le liquide se soit solidifié de manière isotherme en raison de la diffusion à l'intérieur de la couche intermédiaire et ait créé une couche intermédiaire suffisamment homogénéisée, et durcie par précipitation en maintenant la couche intermédiaire à une température de durcissement inférieure à la température de liaison pendant une période de temps spécifiée.

12. Ensemble lié (10) selon la revendication 11, dans lequel :
la couche intermédiaire (12) est un mélange de deux éléments métalliques qui peuvent exister en une ou plusieurs phases en fonction de la température et des concentrations relatives des deux éléments ;
un diagramme de phases du mélange comporte une région à deux phases ; et
la température de liaison et les épaisseurs de couche intermédiaire sont choisies pour produire une composition de solution solide juste à l'extérieur de la région à deux phases des composants de couche intermédiaire.

13. Ensemble lié (10) selon la revendication 11, dans lequel :
les deux couches minces (18, 20) sont constituées du même matériau, ou les deux couches minces (18, 20) sont constituées de matériaux différents, ou la couche réfractaire (22) est constituée d'un matériau réfractaire et les couches minces (18, 20) sont constituées d'un second matériau ayant un point de fusion inférieur à celui du matériau réfractaire, ou les couches minces (18, 20) et la couche réfractaire (22) sont constituées de matériaux métalliques, ou le premier matériau (14) est non métallique et le second matériau (16) est métallique, ou le premier matériau (14) est non métallique et le second matériau (16) est non métallique.

14. Ensemble lié (10) selon la revendication 10, comprenant en outre :
une couche intermédiaire (12) disposée entre les premier et second matériaux (14, 16), la couche intermédiaire (12) comprenant un mélange homogénéisé durci par précipitation et solidifié de manière isotherme d'un élément réfractaire métallique et d'un élément à couche mince métallique ayant un point de fusion inférieur à celui du matériau réfractaire métallique.

15. Ensemble lié (10) selon la revendication 14, dans lequel :
le premier matériau (14) est un revêtement céramique ; et
le second matériau (16) est un substrat métallique.
